# EUROPEAN PATENT SPECIFICATION

(11) **EP 3 354 119 B1**
(45) Date of publication and mention of the grant of the patent: **07.04.2021**
(21) Application number: 15766166.1
(22) Date of filing: 21.09.2015
(51) Int. Cl.: H05K 7/20

(54) **COOLING ARRANGEMENT FOR EXAMPLE FOR COOLING A CONVERTER VALVE HALL**
KÜHLANORDNUNG ZUM BEISPIEL ZUR KÜHLUNG EINER WANDLERVENTILHALLE
AGENCEMENT DE REFROIDISSEMENT POUR REFROIDIR, PAR EXEMPLE, UNE CHAMBRE DE SOUPAPE DE CONVERTISSEUR

(43) Date of publication of application: 01.08.2018
(73) Proprietor: ABB Power Grids Switzerland AG, 5400 Baden (CH)
(72) Inventor: SANDIN, Björn, 771 60 Ludvika (SE); GILLBERG, Curt, 777 60 Söderbärke (SE)
(74) Representative: AWA Sweden AB
(86) International application number: PCT/EP2015/071554
(87) International publication number: WO 2017/050344

(56) References cited:
- EP-A1- 2 059 105
- EP-A2- 2 169 328
- DE-C1- 19 815 645
- US-A1- 2006 214 014
- US-A1- 2008 270 572
- US-A1- 2009 126 909
- US-A1- 2010 275 618
- US-A1- 2014 163 764
- US-B1- 6 185 116

## Description

### TECHNICAL FIELD

The present invention generally relates to the field of cooling of electric equipment. Specifically, the present invention relates to a cooling arrangement for cooling an enclosed, open space, within which electric equipment, e.g. comprising power electronics equipment, is arranged.

### BACKGROUND

HVDC power transmission has become increasingly important due to increasing need for power supply or delivery and interconnected power transmission and distribution systems. In a HVDC power system there is generally included an interface arrangement including or constituting a HVDC converter station, which is a type of station configured to convert high voltage DC to AC, or vice versa. A HVDC converter station may comprise a plurality of elements such as the converter itself (or a plurality of converters connected in series or in parallel), one or more transformers, capacitors, filters, and/or other auxiliary elements. Converters, which often are referred to as 'converter valves', or simply 'valves', may comprise a plurality of solid-state based devices such as semiconductor devices and may be categorized as line-commutated converters (LCCs) or voltage source converters (VSCs), e.g. depending on the type of switches (or switching devices) which are employed in the converter. A plurality of solid-state semiconductor devices such as IGBTs may be connected together, for instance in series, to form a building block, or cell, of a HVDC converter, or HVDC converter valve.

HVDC converter valves are often arranged indoors, in so called converter valve halls. In a converter valve hall it is often desired or even required that the air temperature does not exceed a threshold temperature (e.g., about 60°C, but may depend for example on the particular configuration and/or type of the HVDC converter valve), for example in view of electrical insulation properties and thermal aging of converter valve equipment, which may be unacceptably rapid at higher ambient (e.g., air) temperatures. Thermal losses of a HVDC converter valve may be up to several MW. The majority of the thermal losses are often cooled by way of a circulating cooling medium (e.g., a cooling liquid) that cools the HVDC converter valve. At most only a few kW are normally air cooled. The cooling of the HVDC converter valves may be carried out by means of a liquid cooling system having a cooling capacity of up to several MW. Such a liquid cooling system may for example comprise a so called cooling tower. Such a liquid cooling system is often arranged outside the converter valve hall, and is connected to the HVDC converter valve(s) by way of a cooling circuit connected to the HVDC converter valve(s). Such a liquid cooling system in general has two main temperatures characterizing its operation: a relatively low inlet temperature at an inlet position that is upstream with respect to the HVDC converter valve(s) and an outlet temperature, which is higher than the inlet temperature, at an outlet position that is downstream with respect to the HVDC converter valve(s). The ambient temperature inside the converter valve hall (which often is the air temperature inside the converter valve hall) is determined by the average temperature of the cooling liquid and the ambient temperature outside the converter valve hall.

Recently there has been interest in HVDC converter valves which employ a relatively large number of air cooled power capacitors. Other types of air cooled devices may also possibly be arranged in the converter valve hall. This may increase the air cooled thermal losses within the converter valve hall. One way to decrease the ambient temperature (e.g., air temperature) within an enclosed space, such as within a converter valve hall, is to use air conditioning within the enclosed space. That is to say, to use active air cooling within the enclosed space. An air conditioning system normally uses a cooling machine, which is a relatively complex machine that may have a relatively low operational reliability. The use of such cooling machines may entail that a relatively complex system which may affect or even be critical to the operation of the HVDC converter valve is introduced in the overall HVDC converter system or HVDC converter station. The operational reliability of the overall HVDC converter system or HVDC converter station may thereby decrease.

US 2008/270572 discloses scalable computing pods that may be embodied in trailers, storage containers, or other portable structures that optimize computing, power, cooling and building infrastructure. The pods integrate required power and cooling infrastructure to provide a standalone turnkey computing solution. A user connects the pod to utility AC power and a data pipe. The scalable computing pods utilize liquid cooling, eliminate coolant conversions, and eliminate unnecessary power conversion to drastically improve efficiency.

US 6185116 discloses a device for supervising the cooling of a cooling system of a valve of a high voltage converter station located on high voltage potential level. The device comprises members located on high voltage potential level and adapted to detect the temperature at cooling blocks of the valve on high voltage potential level and send values so detected to first control units for controlling semiconductor components of the valve. The first control units have means for treating said values detected and the first control units are adapted to send data resulting from said treatment to an arrangement for supervising said valve located on low potential level.

### SUMMARY

As mentioned in the foregoing, HVDC converter valves are normally placed indoors, in so called converter valve halls. The air temperature within the converter valve hall should preferably be below a predefined value, e.g. about 60 °C due to electrical insulation properties and thermal aging of converter valve equipment. The temperature within the converter valve hall is often assumed to always be below the predefined value (for example about 60 °C). The temperature of a cooling liquid, which is used in a liquid cooling system for cooling of the HVDC converter valve(s) within the converter valve hall, is at an inlet position upstream with respect to the HVDC converter valve(s) normally approximately 5 K above the ambient temperature outside the converter valve hall. The ambient temperature outside the converter valve hall (for example outdoors) is generally not more than 45 °C. This means that cooling liquid with a temperature of not more than 50°C may be available in the converter valve hall. Simulations that have been made by the inventors have indicated that air cooled thermal losses up to approximately 30 kW can be introduced in a converter valve hall without exceeding air temperatures of 60 °C within the converter valve hall. Thus, in this case, up to 30 kW air cooled thermal losses within the converter valve hall would be 'acceptable'. As mentioned in the foregoing, there has recently been interest in HVDC converter valves which employ a relatively large number of air cooled power capacitors. Possibly, also other air cooled devices may be arranged in the converter valve hall. If such air cooled devices are employed, it is estimated that air cooled thermal losses up to about 100 kW or more will be introduced in the converter valve hall. Simulations that have been made by the inventors have indicated ambient (e.g., air) temperatures within the converter valve hall that are significantly above 60 °C assuming 100 kW air cooled thermal losses.

In view of the above, a concern of the present invention is provide a cooling arrangement that is capable of providing a relatively effective cooling of an enclosed, open space, within which there is electric equipment arranged, which generates heat when in use, that may heat an atmosphere (e.g., air) within the enclosed, open space.

A further concern of the present invention is to provide a cooling arrangement that is capable of providing a relatively effective cooling of an enclosed, open space within which there is a converter valve, e.g. a HVDC converter valve, arranged.

A further concern of the present invention is to provide such a cooling arrangement that is capable of providing a relatively effective cooling of an enclosed, open space while maintaining or at least not substantially increasing the overall complexity of an electric system in which the electric equipment is included.

A further concern of the present invention is to provide such a cooling arrangement that is capable of providing a relatively effective cooling of an enclosed, open space with no or a relatively low need of cooling machines such as air conditioning systems.

To address at least one of these concerns and other concerns, a converter valve hall, a cooling system in a converter valve hall, and a method in converter valve hall in accordance with the independent claims 1, 8 and 11, respectively, are provided, which independent claims 1, 8 and 11 define the present invention. Preferred embodiments are defined by the dependent claims.

According to a first aspect, there is provided a cooling arrangement for use in conjunction with a first cooling circuit and at least one exterior heat exchanger unit. The cooling arrangement is for cooling an enclosed, open space, within which enclosed, open space electric equipment, e.g. comprising power electronics equipment, is arranged. The electric equipment is coupled to the first cooling circuit which extends to the outside of the enclosed, open space. The first cooling circuit is configured to convey cooling medium between the electric equipment and the at least one exterior heat exchanger unit which is arranged outside the enclosed, open space for cooling the electric equipment. The cooling arrangement comprises at least one interior heat exchanger unit which can be arranged, or is arrangeable, within the enclosed, open space. The cooling arrangement comprises a second cooling circuit, which is configured so that it can be coupled to the at least one interior heat exchanger unit. The second cooling circuit is configured to convey cooling medium to and from the at least one interior heat exchanger unit. The second cooling circuit is configured so that it can be coupled to the first cooling circuit such that the at least one interior heat exchanger unit, by means of the first cooling circuit and the second cooling circuit, becomes, or is, coupled in parallel with the electric equipment.

By way of the first cooling circuit, which hence is configured to convey cooling medium between the electric equipment and at least one exterior heat exchanger unit, the electric equipment can be cooled by way of being cooled by the circulation of relatively cold cooling medium, which may be cooler than the electric equipment, thereby causing a transfer of heat from the electric equipment to the cooling medium conveyed in the first cooling circuit. The at least one interior heat exchanger unit, which by means of the first cooling circuit and the second cooling circuit can be coupled in parallel with the electric equipment, can utilize a part or portion of the cooling medium which is conveyed between the at least one exterior heat exchanger unit and the electric equipment via the first cooling circuit in order to cool the enclosed, open space. That is to say, the at least one interior heat exchanger unit may utilize the conveyance or flow of cooling medium between the electric equipment and at least one exterior heat exchanger unit for cooling the enclosed, open space, e.g. so as to cool a gas or atmosphere within the enclosed, open space. The gas or atmosphere within the enclosed, open space may for example comprise air. Thereby, the enclosed, open space may be cooled without or with less need of using equipment such as an air condition apparatus or another apparatus using a cooling machine for active cooling of the atmosphere within the enclosed, open space (the atmosphere e.g. comprising air).

As mentioned in the foregoing, the gas or atmosphere within the enclosed, open space may for example comprise air. Thus, in the context of the present application, by an atmosphere within a space, it is not necessarily meant air being present within the space. In the context of the present application, by an atmosphere within a space it is rather meant a fluid in general that is present within the space, which fluid may comprise air, but which in alternative may comprise a fluid or gas other than air.

Also, compared to employing equipment such as an air condition apparatus, the total amount of power required for cooling the atmosphere within the enclosed, open space may be reduced. The cooling arrangement may need some additional power in order to achieve the flow or conveyance of cooling medium to and from the at least one interior heat exchanger unit (e.g., by means of at least one pump device or the like, or any other appropriate means for realizing or implementing conveyance of cooling medium as known in the art). However, it is contemplated that this additional power will be less than the power required for powering equipment such as an air condition apparatus for achieving a particular capacity or capability of cooling the atmosphere within the enclosed, open space. Also, the cost for the overall cooling system may be less as compared to employing equipment such as an air condition apparatus.

Since the at least one interior heat exchanger unit may utilize the conveyance or flow of cooling medium between the electric equipment and the at least one exterior heat exchanger unit for cooling the enclosed, open space, an already available system for cooling can be employed for providing cooling of the enclosed, open space. Thus, an existing cooling system may relatively easily be retrofitted with the at least one interior heat exchanger unit and the second cooling circuit in order to provide cooling of the enclosed, open space.

The electric equipment may for example comprise a converter valve, such as a HVDC converter valve. Converter valves are often arranged indoors, in so called converter valve halls. In a converter valve hall it is often desired or even required that the air temperature does not exceed threshold temperature so as to reduce or slow down thermal aging of converter valve equipment. In alternative or in addition the electric equipment may for example comprise air cooled power capacitors, which for example may be included in a HVDC converter valve. In such and other cases the cooling arrangement can be used to decrease the temperature of the atmosphere within the enclosed, open space, within which the electric equipment is arranged, which in turn may decrease power capacitor losses and/or increase the operational lifetime of the electric equipment or at least of components thereof, and/or decrease the need for maintenance of the electric equipment due to thermal aging.

As indicated in the foregoing, the cooling arrangement may for example be configured to cool an atmosphere within the enclosed, open space. The atmosphere may for example comprise a gas such as air.

The electric equipment may in principle be any type of electric equipment for which cooling thereof may be desired or even required. Embodiments of the present invention are contemplated to be especially advantageous with regard to electric equipment that is relatively large and which may be required or desired to be installed in a dedicated or purpose-built structure or building. The electric equipment may for example comprise power electronics equipment, which may include or be constituted by, or be electrically connected to, at least a portion of a power system. Embodiments of the present invention are contemplated to be especially advantageous with respect to power electronics equipment requiring a relatively large distance (e.g. air clearance) to surrounding walls, floor, ceiling, etc., in such a dedicated or purpose-built structure or building during operation in order to conform to security requirements, e.g. due to a relatively high operating voltage or rated voltage of the power electronics equipment.

In the context of the present application, by power electronics equipment it is meant equipment relating to power electronics. The power electronics equipment may for example include at least one power converter element or assembly, a transformer, a capacitor, a filter, etc.

The power electronics equipment may for example include or be constituted by at least a portion of a power system. In the context of the present application, at least a portion of a power system should be understood as possibly at least one component or element which may be part of a power system (e.g. a power transmission system), possibly electrically connected with one or more other components or elements included in the power system.

According to one or more embodiments of the present invention, the power electronics equipment or the at least a portion of a power system may comprise or be constituted by a converter, e.g. a HVDC converter, which may be referred to as a valve.

The enclosed, open space may for example be located within a building or structure, which may be configured to house or accommodate the power electronics equipment. For example in case the power electronics equipment comprises or is constituted by a converter, or valve, the enclosed, open space may be located within a so called converter valve hall in which the converter or valve is arranged. The enclosed, open space may possibly be defined by inner surfaces of the walls of the converter valve hall. In a converter valve hall or another type of building or structure configured so as to accommodate one or more power converting devices or elements and/or other power electronics equipment, the atmosphere within the converter valve hall, building or structure may for example comprise air.

The second cooling circuit may for example be arranged at least in part, or even in its entirety, within the enclosed, open space.

The second cooling circuit may be configured so that it can be coupled to the first cooling circuit such that the at least one interior heat exchanger unit by means of the first cooling circuit and the second cooling circuit becomes, or is, coupled in parallel also with the at least one exterior heat exchanger unit.

The first cooling circuit may include an inlet conduit which may be configured to convey cooling medium from the at least one exterior heat exchanger unit to the electric equipment. The first cooling circuit may include an outlet conduit which may be configured to convey cooling medium from the electric equipment to the at least one exterior heat exchanger unit.

The second cooling circuit may include an inlet conduit which may be configured so that it can be coupled to the inlet conduit of the first cooling circuit. The inlet conduit of the second cooling circuit may be configured to convey cooling medium from the inlet conduit of the first cooling circuit to the at least one interior heat exchanger unit. The inlet conduit of the second cooling circuit may for example be coupled to the inlet conduit of the first cooling circuit downstream the at least one exterior heat exchanger unit and within the enclosed, open space. The second cooling circuit may include an outlet conduit which may be configured so that it can be coupled to the outlet conduit of the first cooling circuit. The outlet conduit of the second cooling circuit may be configured to convey cooling medium from the at least one interior heat exchanger unit to the outlet conduit of the first cooling circuit. The outlet conduit of the second cooling circuit may for example be coupled to the outlet conduit of the first cooling circuit downstream the electric equipment and within the enclosed, open space.

The at least one interior heat exchanger unit may be controllable with respect to operation thereof. The at least one interior heat exchanger unit may for example comprise at least one fan or the like which may be controllable for example with respect to speed of rotation.

The cooling arrangement may comprise a control unit. The control unit may be configured to control operation of the at least one interior heat exchanger unit based on temperature within the enclosed, open space.

Temperature within the enclosed, open space may for example be sensed by a temperature sensor, which hence may be configured to sense temperature within the enclosed, open space. The temperature sensor may be included in the cooling arrangement.

The control unit may for example be configured to control operation of the at least one interior heat exchanger unit based on temperature within the enclosed, open space.

The control unit may for example be configured to control operation of the at least one interior heat exchanger unit based on temperature within the enclosed, open space, for example so as to decrease heat transfer between the cooling medium, which is conveyed to the at least one interior heat exchanger unit by way of the second cooling circuit, and an atmosphere (e.g., a fluid such as air) within the enclosed, open space.

The first cooling circuit and/or the second cooling circuit may for example be configured to convey cooling medium by way of or by utilizing at least one pump device or the like, or any other appropriate means for realizing or implementing conveyance of cooling medium as known in the art.

According to one or embodiments of the present invention, the at least one interior heat exchanger unit may for example comprise a liquid to gas heat exchanger.

The cooling medium conveyed between the electric equipment and the at least one exterior heat exchanger unit may for example comprise cooling liquid.

According to one or embodiments of the present invention, the at least one exterior heat exchanger unit may for example comprise a liquid to gas heat exchanger. The at least one exterior heat exchanger unit may for example comprise a so called cooling tower.

According to a second aspect, there is provided a cooling system for cooling an enclosed, open space within which electric equipment is arranged. The cooling system comprises a first cooling circuit which extends to the outside of the enclosed space. The cooling system comprises at least one exterior heat exchanger unit, which is arranged outside the enclosed, open space. The first cooling circuit is configured to convey cooling medium between the electric equipment and the at least one exterior heat exchanger unit for cooling the electric equipment. The cooling system comprises a cooling arrangement according to the first aspect for cooling the enclosed, open space. The electric equipment may for example comprise power electronics equipment. The electric equipment may for example comprise a converter, such as, for example, a HVDC converter.

In accordance with the second aspect, the at least one interior heat exchanger unit is arranged within the enclosed, open space, and the second cooling circuit is coupled to the at least one interior heat exchanger unit and is configured to convey cooling medium to and from the at least one interior heat exchanger unit. Further in accordance with the second aspect, the second cooling circuit is coupled to the first cooling circuit such that the at least one interior heat exchanger unit by means of the first cooling circuit and the second cooling circuit is coupled in parallel with the electric equipment.

According to a third aspect, there is provided a method of constructing a cooling arrangement for cooling an enclosed, open space within which electric equipment is arranged, wherein the electric equipment is coupled to a first cooling circuit which extends to the outside of the enclosed, open space, and wherein the first cooling circuit is configured to convey cooling medium between the electric equipment and at least one exterior heat exchanger unit arranged outside the enclosed, open space for cooling the electric equipment. The method comprises arranging at least one interior heat exchanger unit within the enclosed, open space. A second cooling circuit is coupled to the at least one interior heat exchanger unit so as to permit conveying cooling medium to and from the at least one interior heat exchanger unit via the second cooling circuit. The second cooling circuit is coupled to the first cooling circuit such that the at least one interior heat exchanger unit by means of the first cooling circuit and the second cooling circuit is coupled in parallel with the electric equipment.

Further objects and advantages of the present invention are described in the following by means of exemplifying embodiments. It is noted that the present invention relates to all possible combinations of features recited in the claims. Further features of, and advantages with, the present invention will become apparent when studying the appended claims and the description herein.

### BRIEF DESCRIPTION OF THE DRAWINGS

Exemplifying embodiments of the present invention will be described below with reference to the accompanying drawings.
Figure 1 is a schematic block diagram of a cooling system according to an embodiment of the present invention.
Figure 2 is a schematic flowchart of a method according to an embodiment of the present invention.

All the figures are schematic, not necessarily to scale, and generally only show parts which are necessary in order to elucidate embodiments of the present invention, wherein other parts may be omitted or merely suggested.

### DETAILED DESCRIPTION

The present invention will now be described hereinafter with reference to the accompanying drawings, in which exemplifying embodiments of the present invention are shown. The present invention may, however, be embodied in many different forms and should not be construed as limited to the embodiments of the present invention set forth herein; rather, these embodiments are provided by way of example so that this disclosure will convey the scope of the present invention to those skilled in the art.

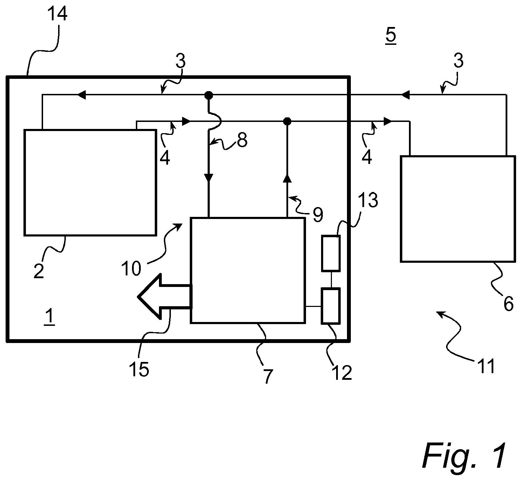

Figure 1 is schematic block diagram of a cooling system 11 according to an embodiment of the present invention. The cooling system 11 is configured to cool an enclosed, open space 1. Electric equipment 2 is arranged within the enclosed, open space 1. According to the embodiment of the present invention illustrated in Figure 1, the electric equipment 2 comprises a HVDC converter valve, and the enclosed, open space 1 is an open space within a so called HVDC converter valve hall 14. However, although the embodiment of the present invention illustrated in Figure 1 is described in relation to HVDC converter valve hall 14 which houses or accommodates one or more HVDC converter valves, it is to be understood that embodiments of the present invention are not limited thereto. One or more embodiments of the present invention are contemplated to be advantageous with respect to in principle any type of electric equipment 2, especially for such electric equipment 2 for which cooling thereof may be desired or even required, and which may be relatively large and required or desired to be installed in a dedicated or purpose-built structure or building (at least in part defining an enclosed, open space).

The cooling system 11 comprises a first cooling circuit 3, 4, which extends to the outside 5 of the enclosed space 1, and an exterior heat exchanger unit 6, which is arranged outside the enclosed, open space 1.

The first cooling circuit 3, 4 is configured to convey cooling medium between the electric equipment 2 and the exterior heat exchanger unit 6 for cooling the electric equipment 2. The first cooling circuit 3, 4 may for example be configured to convey cooling medium by way of or by utilizing at least one pump device or the like (not shown in Figure 1), and/or any other appropriate means for realizing or implementing conveyance of cooling medium as known in the art.

The cooling system 11 comprises a cooling arrangement 10 for cooling the enclosed, open space 1. The cooling arrangement 10 may for example be configured to cool an atmosphere within the enclosed, open space 1. The atmosphere within the enclosed, open space 1 may for example comprise a gas such as air. That is to say, the cooling arrangement 10 may be configured to cool a fluid, e.g. a gas such as air, within the enclosed, open space 1.

The cooling arrangement 10 comprises an interior heat exchanger unit 7 that is arranged within the enclosed, open space 1, and a second cooling circuit 8, 9, which is coupled to the interior heat exchanger unit 7 and which is configured to convey cooling medium to and from the interior heat exchanger unit 7. The second cooling circuit 8, 9 may for example be configured to convey cooling medium by way of or by utilizing at least one pump device or the like (not shown in Figure 1), and/or any other appropriate means for realizing or implementing conveyance of cooling medium as known in the art. The second cooling circuit 8, 9 is coupled to the first cooling circuit 3, 4 for example such as illustrated in Figure 1, such that the interior heat exchanger unit 7 by means of the first cooling circuit 3, 4 and the second cooling circuit 8, 9 is coupled in parallel with the electric equipment 2.

According to the embodiment of the present invention illustrated in Figure 1, the first cooling circuit 3, 4 may include an inlet conduit 3 that is configured to convey cooling medium from the exterior heat exchanger unit 6 to the electric equipment 2, and an outlet conduit 4 configured to convey cooling medium from the electric equipment 2 to the exterior heat exchanger unit 6.

Further according to the embodiment of the present invention illustrated in Figure 1, the second cooling circuit 8, 9 may include an inlet conduit 8 coupled to the inlet conduit 3 of the first cooling circuit 3, 4. The inlet conduit 8 of the second cooling circuit 8, 9 may be configured to convey cooling medium from the inlet conduit 3 of the first cooling circuit 3, 4 to the interior heat exchanger unit 7. As illustrated in Figure 1, the second cooling circuit 8, 9 may comprise an outlet conduit 9 coupled to the outlet conduit 4 of the first cooling circuit 3, 4. The outlet conduit 9 of the second cooling circuit 8, 9 may be configured to convey cooling medium from the interior heat exchanger unit 7 to the outlet conduit 4 of the first cooling circuit 3, 4.

By way of the second cooling circuit 8, 9, which is coupled to the interior heat exchanger unit 7 and which is configured to convey cooling medium to and from the interior heat exchanger unit 7, the temperature of the atmosphere within the enclosed, open space 1 may be decreased. The atmosphere within the enclosed, open space 1 may for example comprise air, such that the cooling arrangement 10 may be configured to cool air within the enclosed, open space 1. By way of operation of the interior heat exchanger unit 7, cool air, schematically indicated at 15, can be introduced within the enclosed, open space 1 for cooling the air therein.

The interior heat exchanger unit 7 may for example comprise a liquid to gas heat exchanger. The interior heat exchanger unit 7 may for example comprise a so called 'dry cooler', e.g. of model "KCE", manufactured by Luvata, which dry cooler may utilize air as secondary fluid.

The exterior heat exchanger unit 6 may for example comprise a so called cooling tower, which may utilize water as secondary fluid. However, it is to be understood that the exterior heat exchanger unit 6 may be based on another type or other types of heat exchangers. The exterior heat exchanger unit 6 may for example comprise a liquid to gas heat exchanger. The cooling medium conveyed between the electric equipment 2 and the exterior heat exchanger unit 6 may for example comprise a cooling liquid. The exterior heat exchanger unit 6 and the first cooling circuit 3, 4 may have a cooling capacity of up to several MW for cooling of the electrical equipment 2. Such a cooling capacity may be advantageous for example for the case where the electric equipment 2 comprises one or more HVDC converter valves.

The cooling medium which may be used in the cooling system 11 may for example comprise a liquid such as water, any appropriate oil, a combination (e.g., a mixture) of water and glycol, or any combination thereof.

Even though the interior heat exchanger unit 7 and the exterior heat exchanger unit 6 are described with reference to Figure 1 as being of liquid to gas heat exchanger type, it is to be understood that this is according to an exemplifying embodiment of the present invention, and that the interior heat exchanger unit 7 and the exterior heat exchanger unit 6 may be of another type of heat exchanger.

Even though the atmosphere within the enclosed, open space 1 of the cooling system 11 described with reference to Figure 1 comprises air, it is to be understood that this is according to an exemplifying embodiment of the present invention, and that the atmosphere within the enclosed, open space 1 for example may comprise another gas than air, or a mixture of air and another gas or other gases.

Principles of embodiments of the present invention will in the following be described with reference to an example where the air temperature within the HVDC converter valve hall 14 preferably should be below a predefined value, e.g. about 60 °C or some other value, due to electrical insulation properties and thermal aging of converter valve equipment. It is to be understood that the value 60 °C of the air temperature threshold value and other numerical values provided in the following are exemplifying and merely for illustrating principles of embodiments of the present invention, and should not be construed as limiting embodiments of the present invention in any way. The temperature of a cooling medium, e.g. a cooling liquid, which is used in the first cooling circuit 3, 4 and the exterior heat exchanger 6 for cooling of the electric equipment 2, which according to the illustrated embodiment of the present invention comprises HVDC converter valve(s), may at an inlet to the HVDC converter valve hall 14 normally be approximately 5 K above the ambient temperature within the HVDC converter valve hall 14. The ambient temperature outside the HVDC converter valve hall 14 (for example outdoors) is generally not more than 45 °C. Thus, the temperature of the cooling medium may on entering the inside of the HVDC converter valve hall 14 by way of the inlet conduit 3 of the first cooling circuit 3, 4 have a temperature of not more than 50°C. Simulations that have been made by the inventors have indicated that air cooled thermal losses up to approximately 30 kW can be introduced in the HVDC converter valve hall 14 without exceeding ambient temperatures of 60 °C within the HVDC converter valve hall 14. Thus, in this case, up to 30 kW air cooled thermal losses within the HVDC converter valve hall 14 would be 'acceptable'. For example if air cooled devices such as HVDC converter valves which employ a relatively large number of air cooled power capacitors would be arranged in the HVDC converter valve hall 14 and put into operation, air cooled thermal losses up to about 100 kW or more could be introduced in the HVDC converter valve hall 14. Simulations that have been made by the inventors have indicated, assuming 100 kW of air cooled thermal losses within the HVDC converter valve hall 14, ambient (e.g., air) temperatures within the HVDC converter valve hall 14 that could be significantly exceeding 60 °C. In order to keep the ambient (e.g., air) temperature within the HVDC converter valve hall 14 to at most 60 °C (or to some other predefined threshold value of the ambient temperature) the cooling arrangement 10 according to the embodiment illustrated in Figure 1 employs the interior heat exchanger 7 that is connected by way of the second cooling circuit 8, 9 between the inlet conduit 3 of the first cooling circuit 3, 4 and the outlet conduit 4 of the first cooling circuit 3, 4. According to the present example, assuming that air cooled thermal losses up to about 100 kW would be introduced in the HVDC converter valve hall 14 if employing air cooled devices such as HVDC converter valves which employ a relatively large number of air cooled power capacitors cooled power capacitors, the interior heat exchanger 7 would need to 'pick up' about 70 kW from the atmosphere (ambient air) within the enclosed, open space 1 of the HVDC converter valve hall 14, since up to 30 kW air cooled thermal losses within the HVDC converter valve hall 14 would be 'acceptable', as mentioned in the foregoing. Introduction of the interior heat exchanger 7 in the enclosed, open space 1 of the HVDC converter valve hall 14 may increase the required capacity and/or capability of at least one pump device or the like, or any other appropriate means for as known in the art for realizing or implementing flow or conveyance of cooling medium in the cooling system 11. The liquid cooled thermal losses in the HVDC converter valve hall 14 may for example be up to about 1500 kW. Assuming such liquid cooled thermal losses the HVDC converter valve hall 14, an additional 70 kW that is 'picked up' by the interior heat exchanger 7 from the atmosphere (ambient air) within the enclosed, open space 1 of the HVDC converter valve hall 14 may increase the total amount of cooling medium flowing in the cooling system 11 per unit of time by approximately 70/1500 = 4.7%. This calculation is under the assumption that the rises of temperature of the cooling medium both in the HVDC converter valve(s) and in the interior heat exchanger 7 are equal, or substantially equal.

The interior heat exchanger unit 7 may be controllable with respect to operation thereof. The interior heat exchanger unit 7 may for example comprise a liquid to gas heat exchanger, which utilizes air as secondary fluid. As mentioned in the foregoing, the atmosphere within the enclosed, open space 1 of the HVDC converter valve hall 14 may be air. The interior heat exchanger unit 7 may for example comprise one or more fans or the like which may be controllable for example with respect to speed of rotation thereof.

The cooling arrangement 10 or cooling system 11 may comprise a control unit 12. The control unit 12 may control operation of one or more elements or components of the cooling arrangement 10 or cooling system 11, e.g. by way of transmitting control messages, commands, data, etc., to the respective one of the one or more elements or components of the cooling arrangement 10 or cooling system 11. The control unit 12 and the one or more elements or components of the cooling arrangement 10 or cooling system 11 may be configured so as permit communication therebetween, which may be wired and/or wireless, and which for example may employ any known communication method or technique as known in the art, such as but not limited to, optical (e.g., infrared) communication, wireless radio frequency communication, etc.

The control unit 12 may be configured to control operation of the interior heat exchanger unit 7 for example based on temperature within the enclosed, open space 1. Temperature within the enclosed, open space 1 may for example be sensed by a temperature sensor 13. The temperature sensor 13 may hence be configured to sense temperature within the enclosed, open space 1. The temperature sensor 13 may be included in the cooling arrangement 10 or cooling system 11.

The control unit 12 may for example be configured to control operation of the interior heat exchanger unit 7 based on temperature within the enclosed, open space 1 so as to decrease heat transfer between the cooling medium, which is conveyed to the interior heat exchanger unit 7 by the second cooling circuit 8, 9, and air (and/other other fluid) that is present within the enclosed, open space 1.

As mentioned in the foregoing, the interior heat exchanger unit 7 may comprise one or more fans or the like which may be controllable for example with respect to speed of rotation thereof. The control unit 12 may be configured to, in case the sensed temperature within the enclosed, open space 1 exceeds a predefined or selected threshold value (e.g., 55 °C), start or activate operation of the one or more fans or the like, and/or set the speed of rotation thereof to some selected value. If the one or more fans or the like are operating, the control unit 12 may be configured to stop or deactivate operation of the one or more fans or the like (or set the speed of rotation thereof to some selected value) in case the sensed temperature within the enclosed, open space 1 falls below the predefined or selected threshold value.

The second cooling circuit 8, 9 may be controllable so as to selectively and controllably allow for or not allow for flow of cooling medium in the second cooling circuit 8, 9, to and from the interior heat exchanger unit 7. To this end, the second cooling circuit 8, 9 may for example comprise one or more shunt valves or by-pass valves (not shown in Figure 1), by means of which flow of cooling medium from the exterior heat exchanger unit 6 via the inlet conduit 3 of the first cooling circuit 3, 4 may be selectively and controllably restricted or not permitted to enter the inlet conduit 8 of the second cooling circuit 8, 9, and flow of cooling medium from the interior heat exchanger unit 7 via the outlet conduit 9 of the second cooling circuit 8, 9 may be selectively and controllably restricted or not permitted to enter the outlet conduit 4 of the first cooling circuit 3, 4.

The second cooling circuit 8, 9 may be controllable so as to selectively and controllably permit and not permit flow of cooling medium in the second cooling circuit 8, 9, to and from the interior heat exchanger unit 7. The control unit 12 may be configured to control operation of the second cooling circuit 8, 9 so as to not permit flow of cooling medium in the second cooling circuit 8, 9, to and from the interior heat exchanger unit 7 in case the sensed temperature within the enclosed, open space 1 is or falls below a predefined or selected threshold value (e.g., 55 °C). The predefined or selected threshold value may be the same threshold value as used for conditionally starting or stopping operation of the one or more fans or the like as described in the foregoing. If the sensed temperature within the enclosed, open space 1 rises or exceeds the predefined or selected threshold value, the control unit 12 may be configured to control operation of the second cooling circuit 8, 9 so as to not permit flow of cooling medium in the second cooling circuit 8, 9, to and from the interior heat exchanger unit 7.

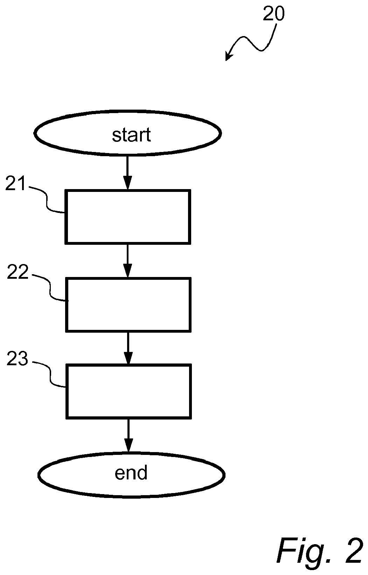

Referring now to Figure 2, there is shown a schematic flowchart of a method 20 according to an embodiment of the present invention. The method 20 is for constructing a cooling arrangement, e.g. a cooling arrangement 10 as described in the foregoing with reference to Figure 1, for cooling an enclosed, open space, within which electric equipment is arranged. The electric equipment is coupled to a first cooling circuit which extends to the outside of the enclosed, open space. The first cooling circuit is configured to convey cooling medium between the electric equipment and at least one exterior heat exchanger unit, which is arranged outside the enclosed, open space for cooling the electric equipment.

The method 20 comprises:
- arranging at least one interior heat exchanger unit within the enclosed, open space, 21;
- coupling a second cooling circuit to the at least one interior heat exchanger unit so as to permit conveying cooling medium to and from the at least one interior heat exchanger unit via the second cooling circuit, 22; and
- coupling the second cooling circuit to the first cooling circuit such that the at least one interior heat exchanger unit by means of the first cooling circuit and the second cooling circuit is coupled in parallel with the electric equipment, 23.

## Claims

1. A converter valve hall comprising an enclosed, open space (1) within which electric equipment (2) is arranged, the electric equipment comprising power electronics equipment electrically connected to a power transmission system, wherein the converter valve hall further comprises a cooling arrangement (10) for use in conjunction with a first cooling circuit (3, 4) and at least one exterior heat exchanger unit (6) for cooling the enclosed, open space (1), wherein the electric equipment is coupled to the first cooling circuit (3, 4) which extends to the outside (5) of the enclosed, open space, the first cooling circuit being configured to convey cooling medium between the electric equipment and the at least one exterior heat exchanger unit (6) arranged outside the enclosed, open space for cooling the electric equipment, the cooling arrangement comprising:
at least one interior heat exchanger unit (7) arrangeable within the enclosed, open space; and
a second cooling circuit (8, 9) which is configured so that it can be coupled to the at least one interior heat exchanger unit and which is configured to convey cooling medium to and from the at least one interior heat exchanger unit;
wherein the second cooling circuit is configured so that it can be coupled to the first cooling circuit such that the at least one interior heat exchanger unit by means of the first cooling circuit and the second cooling circuit becomes coupled in parallel with the electric equipment; and
wherein the at least one interior heat exchanger unit is controllable with respect to operation thereof, and wherein the cooling arrangement further comprises:
a temperature sensor (13) configured to sense temperature within the enclosed, open space; and
a control unit (12) configured to control operation of the at least one interior heat exchanger unit based on temperature within the enclosed, open space sensed by the temperature sensor.

2. A converter valve hall according to claim 1, wherein the second cooling circuit can be arranged at least in part within the enclosed, open space.

3. A converter valve hall according to claim 1 or 2, wherein the second cooling circuit is configured so that it can be coupled to the first cooling circuit such that the at least one interior heat exchanger unit by means of the first cooling circuit and the second cooling circuit becomes coupled in parallel also with the at least one exterior heat exchanger unit.

4. A converter valve hall according to any one of claims 1-3, wherein the first cooling circuit includes an inlet conduit (3) configured to convey cooling medium from the at least one exterior heat exchanger unit to the electric equipment, and an outlet conduit (4) configured to convey cooling medium from the electric equipment to the at least one exterior heat exchanger unit, wherein the second cooling circuit includes:
an inlet conduit (8) which is configured so that it can be coupled to the inlet conduit of the first cooling circuit, the inlet conduit of the second cooling circuit being configured to convey cooling medium from the inlet conduit of the first cooling circuit to the at least one interior heat exchanger unit; and
an outlet conduit (9) which is configured so that it can be coupled to the outlet conduit of the first cooling circuit, the outlet conduit of the second cooling circuit being configured to convey cooling medium from the at least one interior heat exchanger unit to the outlet conduit of the first cooling circuit.

5. A converter valve hall according to any one of claims 1-4, wherein the at least one interior heat exchanger unit comprises a liquid to gas heat exchanger, and wherein the cooling medium conveyed between the electric equipment and the at least one exterior heat exchanger unit comprises cooling liquid.

6. A converter valve hall according to any one of claims 1-5, wherein the control unit is configured to control operation of the at least one interior heat exchanger unit based on temperature within the enclosed, open space sensed by the temperature sensor so as to control heat transfer between the cooling medium conveyed to the at least one interior heat exchanger unit by the second cooling circuit and an atmosphere within the enclosed, open space.

7. A converter valve hall according to any one of claims 1-6, wherein the converter valve hall is a High Voltage Direct Current, HVDC, converter valve hall.

8. A method (20) for cooling a converter valve hall comprising an enclosed, open space (1) within which electric equipment (2) is arranged, the electric equipment comprising power electronics equipment electrically connected to a power transmission system, wherein the method is for constructing a cooling arrangement (10) for cooling the enclosed, open space (1), wherein the electric equipment is coupled to a first cooling circuit (3, 4) which extends to the outside (5) of the enclosed, open space, the first cooling circuit being configured to convey cooling medium between the electric equipment and at least one exterior heat exchanger unit arranged outside the enclosed, open space for cooling the electric equipment, the method comprising:
arranging (21) at least one interior heat exchanger unit (6) within the enclosed, open space;
coupling (22) a second cooling circuit (7, 8) to the at least one interior heat exchanger unit so as to permit conveying cooling medium to and from the at least one interior heat exchanger unit via the second cooling circuit; and
coupling (23) the second cooling circuit to the first cooling circuit such that the at least one interior heat exchanger unit by means of the first cooling circuit and the second cooling circuit is coupled in parallel with the electric equipment;
wherein the at least one interior heat exchanger unit is controllable with respect to operation thereof, and wherein the method further comprises:
sensing temperature within the enclosed, open space; and
controlling operation of the at least one interior heat exchanger unit based on sensed temperature within the enclosed, open space.

9. A method according to claim 8, comprising:
controlling operation of the at least one interior heat exchanger unit based on sensed temperature within the enclosed, open space so as to control heat transfer between the cooling medium conveyed to the at least one interior heat exchanger unit by the second cooling circuit and an atmosphere within the enclosed, open space.

## Patentansprüche

1. Wandlerventilhalle, umfassend einen eingeschlossenen, offenen Raum (1), innerhalb dessen elektrische Ausrüstung (2) angeordnet ist, wobei die elektrische Ausrüstung Leistungselektronikausrüstung umfasst, die elektrisch mit einem Leistungsübertragungssystem verbunden ist, wobei die Wandlerventilhalle ferner eine Kühlanordnung (10) zur Verwendung in Verbindung mit einem ersten Kühlkreis (3, 4) und zumindest eine äußere Wärmetauschereinheit (6) zum Kühlen des eingeschlossenen, offenen Raumes (1) umfasst, wobei die elektrische Ausrüstung mit dem ersten Kühlkreis (3, 4) gekoppelt ist, der sich zur Außenseite (5) des eingeschlossenen, offenen Raumes erstreckt, wobei der erste Kühlkreis dazu ausgelegt ist, Kühlmedium zwischen der elektrischen Ausrüstung und der zumindest einen äußeren Wärmetauschereinheit (6), angeordnet außerhalb des eingeschlossenen, offenen Raumes, zum Kühlen der elektrischen Ausrüstung zu befördern, wobei die Kühlanordnung Folgendes umfasst:
zumindest eine innere Wärmetauschereinheit (7), anordenbar innerhalb des eingeschlossenen, offenen Raumes; und
einen zweiten Kühlkreis (8, 9), der so ausgelegt ist, dass er mit der zumindest einen inneren Wärmetauschereinheit gekoppelt werden kann, und der dazu ausgelegt ist, Kühlmedium zur und von der inneren Wärmetauschereinheit zu befördern;
wobei der zweite Kühlkreis so ausgelegt ist, dass er mit dem ersten Kühlkreis gekoppelt werden kann, sodass die zumindest eine innere Wärmetauschereinheit mittels des ersten Kühlkreises und des zweiten Kühlkreises parallel mit der elektrischen Ausrüstung gekoppelt wird; und
wobei die zumindest eine innere Wärmetauschereinheit bezüglich des Betriebs davon steuerbar ist, und wobei die Kühlanordnung ferner Folgendes umfasst:
einen Temperatursensor (13), ausgelegt zum Erfassen von Temperatur innerhalb des eingeschlossenen, offenen Raumes; und
eine Steuereinheit (12), ausgelegt zum Steuern des Betriebs der zumindest einen inneren Wärmetauschereinheit basierend auf der Temperatur innerhalb des eingeschlossenen, offenen Raumes, die durch den Temperatursensor erfasst wird.

2. Wandlerventilhalle nach Anspruch 1, wobei der zweite Kühlkreis zumindest teilweise innerhalb des eingeschlossenen, offenen Raumes angeordnet sein kann.

3. Wandlerventilhalle nach Anspruch 1 oder 2, wobei der zweite Kühlkreis so ausgelegt ist, dass er mit dem ersten Kühlkreis gekoppelt werden kann, sodass die zumindest eine innere Wärmetauschereinheit mittels des ersten Kühlkreises und des zweiten Kühlkreises auch parallel mit der zumindest einen äußeren Wärmetauschereinheit gekoppelt wird.

4. Wandlerventilhalle nach einem der Ansprüche 1-3, wobei der erste Kühlkreis eine Einlassleitung (3), ausgelegt zum Befördern von Kühlmedium von der zumindest einen äußeren Wärmetauschereinheit zur elektrischen Ausrüstung, und eine Auslassleitung (4), ausgelegt zum Befördern von Kühlmedium von der elektrischen Ausrüstung zu der zumindest einen äußeren Wärmetauschereinheit, umfasst, wobei der zweite Kühlkreis Folgendes umfasst:
eine Einlassleitung (8), die so ausgelegt ist, dass sie mit der Einlassleitung des ersten Kühlkreises gekoppelt werden kann, wobei die Einlassleitung des zweiten Kühlkreises ausgelegt ist zum Befördern von Kühlmedium von der Einlassleitung des ersten Kühlkreises zu der zumindest einen inneren Wärmetauschereinheit; und
eine Auslassleitung (9), die so ausgelegt ist, dass sie mit der Auslassleitung des ersten Kühlkreises gekoppelt werden kann, wobei die Auslassleitung des zweiten Kühlkreises ausgelegt ist zum Befördern von Kühlmedium von der zumindest einen inneren Wärmetauschereinheit zur Auslassleitung des ersten Kühlkreises.

5. Wandlerventilhalle nach einem der Ansprüche 1-4, wobei die zumindest eine innere Wärmetauschereinheit einen Flüssigkeit-zu-Gas-Wärmetauscher umfasst, und wobei das zwischen der elektrischen Ausrüstung und der zumindest einen äußeren Wärmetauschereinheit beförderte Kühlmedium eine Kühlflüssigkeit umfasst.

6. Wandlerventilhalle nach einem der Ansprüche 1-5, wobei die Steuereinheit ausgelegt ist zum Steuern des Betriebs der zumindest einen inneren Wärmetauschereinheit basierend auf der Temperatur innerhalb des eingeschlossenen, offenen Raumes, die durch den Temperatursensor erfasst wird, um Wärmeübertragung zwischen dem durch den zweiten Kühlkreis zu der zumindest einen inneren Wärmetauschereinheit beförderten Kühlmedium und einer Atmosphäre innerhalb des eingeschlossenen, offenen Raumes zu steuern.

7. Wandlerventilhalle nach einem der Ansprüche 1-6, wobei die Wandlerventilhalle eine Hochspannungs-Gleichstrom-Wandlerventilhalle (HVDC) ist.

8. Verfahren (20) zum Kühlen einer Wandlerventilhalle, umfassend einen eingeschlossenen, offenen Raum (1), innerhalb dessen elektrische Ausrüstung (2) angeordnet ist, wobei die elektrische Ausrüstung Leistungselektronikausrüstung umfasst, die elektrisch mit einem Leistungsübertragungssystem verbunden ist, wobei das Verfahren dient zum Konstruieren einer Kühlanordnung (10) zum Kühlen des eingeschlossenen, offenen Raumes (1), wobei die elektrische Ausrüstung mit einem ersten Kühlkreis (3, 4) gekoppelt ist, der sich zur Außenseite (5) des eingeschlossenen, offenen Raumes erstreckt, wobei der erste Kühlkreis dazu ausgelegt ist, Kühlmedium zwischen der elektrischen Ausrüstung und der zumindest einen äußeren Wärmetauschereinheit, angeordnet außerhalb des eingeschlossenen, offenen Raumes zum Kühlen der elektrischen Ausrüstung, zu befördern, wobei das Verfahren Folgendes umfasst:
Anordnen (21) zumindest einer inneren Wärmetauschereinheit (6) innerhalb des eingeschlossenen, offenen Raumes;
Koppeln (22) eines zweiten Kühlkreises (7, 8) mit der zumindest einen inneren Wärmetauschereinheit, um Befördern von Kühlmedium zur und von der zumindest einen inneren Wärmetauschereinheit über den zweiten Kühlkreis zu ermöglichen; und
Koppeln (23) des zweiten Kühlkreises mit dem ersten Kühlkreis, sodass die zumindest eine innere Wärmetauschereinheit mittels des ersten Kühlkreises und des zweiten Kühlkreises parallel mit der elektrischen Ausrüstung gekoppelt wird;
wobei die zumindest eine innere Wärmetauschereinheit bezüglich des Betriebs davon steuerbar ist, und wobei das Verfahren ferner Folgendes umfasst:
Erfassen von Temperatur innerhalb des eingeschlossenen, offenen Raumes; und
Steuern des Betriebs der zumindest einer inneren Wärmetauschereinheit basierend auf der erfassten Temperatur innerhalb des eingeschlossenen, offenen Raumes.

9. Verfahren nach Anspruch 8, das Folgendes umfasst:
Steuern des Betriebs der zumindest einen inneren Wärmetauschereinheit basierend auf der erfassten Temperatur innerhalb des eingeschlossenen, offenen Raumes, um Wärmeübertragung zwischen dem durch den zweiten Kühlkreis zu der zumindest einen inneren Wärmetauschereinheit beförderten Kühlmedium und einer Atmosphäre innerhalb des eingeschlossenen, offenen Raumes zu steuern.

## Revendications

1. Salle de valves de conversion, comprenant un espace ouvert clos (1) au sein duquel est agencé un équipement électrique (2), l'équipement électrique comprenant un équipement d'électronique de puissance relié électriquement à un système de transport d'énergie, la salle de valves de conversion comprenant en outre un agencement de refroidissement (10) destiné être utilisé conjointement avec un premier circuit de refroidissement (3, 4) et au moins une unité d'échange de chaleur extérieure (6) destinée à refroidir l'espace ouvert clos (1), l'équipement électrique étant accouplé à un premier circuit de refroidissement (3, 4) qui s'étend jusqu'à l'extérieur (5) de l'espace ouvert clos, le premier circuit de refroidissement étant configuré pour acheminer un agent de refroidissement entre l'équipement électrique et l'au moins une unité d'échange de chaleur extérieure (6) agencée à l'extérieur de l'espace ouvert clos pour le refroidissement de l'équipement électrique, l'agencement de refroidissement comprenant :
au moins une unité d'échange de chaleur intérieure (7) agençable au sein de l'espace ouvert clos ; et
un deuxième circuit de refroidissement (8, 9) qui est configuré de sorte à pouvoir être accouplé à l'au moins une unité d'échange de chaleur intérieure et qui est configuré pour acheminer un agent de refroidissement à destination et en provenance de l'au moins une unité d'échange de chaleur intérieure ;
le deuxième circuit de refroidissement étant configuré de sorte à pouvoir être accouplé au premier circuit de refroidissement de façon à ce que l'au moins une unité d'échange de chaleur intérieure, au moyen du premier circuit de refroidissement et du deuxième circuit de refroidissement, s'accouple en parallèle à l'équipement électrique ; et
l'au moins une unité d'échange de chaleur intérieure étant susceptible d'être commandée s'agissant de son fonctionnement, et l'agencement de refroidissement comprenant en outre :
un capteur de température (13) configuré pour détecter la température au sein de l'espace ouvert clos ; et
une unité de commande (12) configurée pour commander le fonctionnement de l'au moins une unité d'échange de chaleur intérieure en fonction de la température au sein de l'espace ouvert clos détectée par le capteur de température.

2. Salle de valves de conversion selon la revendication 1, dans laquelle le deuxième circuit de refroidissement est agençable au moins en partie au sein de l'espace ouvert clos.

3. Salle de valves de conversion selon la revendication 1 ou 2, dans laquelle le deuxième circuit de refroidissement est configuré de sorte à pouvoir être accouplé au premier circuit de refroidissement de façon à ce que l'au moins une unité d'échange de chaleur intérieure, au moyen du premier circuit de refroidissement et du deuxième circuit de refroidissement, s'accouple en parallèle également à l'au moins une unité d'échange de chaleur extérieure.

4. Salle de valves de conversion selon l'une quelconque des revendications 1 à 3, dans laquelle le premier circuit de refroidissement comporte une conduite d'entrée (3) configurée pour acheminer un agent de refroidissement depuis l'au moins une unité d'échange de chaleur extérieure jusqu'à l'équipement électrique, et une conduite de sortie (4) configurée pour acheminer un agent de refroidissement depuis l'équipement électrique jusqu'à l'au moins une unité d'échange de chaleur extérieure, le deuxième circuit de refroidissement comportant :
une conduite d'entrée (8) qui est configurée de sorte à pouvoir être accouplée à la conduite d'entrée du premier circuit de refroidissement, la conduite d'entrée du deuxième circuit de refroidissement étant configurée pour acheminer un agent de refroidissement depuis la conduite d'entrée du premier circuit de refroidissement jusqu'à l'au moins une unité d'échange de chaleur intérieure ; et
une conduite de sortie (9) qui est configurée de sorte à pouvoir être accouplée à la conduite de sortie du premier circuit de refroidissement, la conduite de sortie du deuxième circuit de refroidissement étant configurée pour acheminer un agent de refroidissement depuis l'au moins une unité d'échange de chaleur intérieure jusqu'à la conduite de sortie du premier circuit de refroidissement.

5. Salle de valves de conversion selon l'une quelconque des revendications 1 à 4, dans laquelle l'au moins une unité d'échange de chaleur intérieure comprend un échangeur de chaleur liquide-gaz, et dans laquelle l'agent de refroidissement acheminé entre l'équipement électrique et l'au moins une unité d'échange de chaleur extérieure comprend un liquide de refroidissement.

6. Salle de valves de conversion selon l'une quelconque des revendications 1 à 5, dans laquelle l'unité de commande est configurée pour commander le fonctionnement de l'au moins une unité d'échange de chaleur intérieure en fonction de la température au sein de l'espace ouvert clos détectée par le capteur de température afin de commander le transfert de chaleur entre l'agent de refroidissement acheminé jusqu'à l'au moins une unité d'échange de chaleur intérieure par le deuxième circuit de refroidissement et une atmosphère au sein de l'espace ouvert clos.

7. Salle de valves de conversion selon l'une quelconque des revendications 1 à 6, laquelle salle de valves de conversion est une salle de valves de conversion à courant continu haute tension, HVDC.

8. Procédé (20) de refroidissement d'une salle de valves de conversion comprenant un espace ouvert clos (1) au sein duquel est agencé un équipement électrique (2), l'équipement électrique comprenant un équipement d'électronique de puissance relié électriquement à un système de transport d'énergie, le procédé permettant la construction d'un agencement de refroidissement (10) destiné à refroidir l'espace ouvert clos (1), l'équipement électrique étant accouplé à un premier circuit de refroidissement (3, 4) qui s'étend jusqu'à l'extérieur (5) de l'espace ouvert clos, le premier circuit de refroidissement étant configuré pour acheminer un agent de refroidissement entre l'équipement électrique et au moins une unité d'échange de chaleur extérieure agencée à l'extérieur de l'espace ouvert clos pour le refroidissement de l'équipement électrique, le procédé comprenant :
l'agencement (21) d'au moins une unité d'échange de chaleur intérieure (6) au sein de l'espace ouvert clos ;
l'accouplement (22) d'un deuxième circuit de refroidissement (7, 8) à l'au moins une unité d'échange de chaleur intérieure afin de permettre l'acheminement d'un agent de refroidissement à destination et en provenance de l'au moins une unité d'échange de chaleur intérieure par le biais du deuxième circuit de refroidissement ; et
l'accouplement (23) du deuxième circuit de refroidissement au premier circuit de refroidissement de façon à ce que l'au moins une unité d'échange de chaleur intérieure, au moyen du premier circuit de refroidissement et du deuxième circuit de refroidissement, s'accouple en parallèle à l'équipement électrique ;
l'au moins une unité d'échange de chaleur intérieure étant susceptible d'être commandée s'agissant de son fonctionnement, et le procédé comprenant en outre :
la détection de la température au sein de l'espace ouvert clos ; et
la commande du fonctionnement de l'au moins une unité d'échange de chaleur intérieure en fonction de la température détectée au sein de l'espace ouvert clos.

9. Procédé selon la revendication 8, comprenant :
la commande du fonctionnement de l'au moins une unité d'échange de chaleur intérieure en fonction de la température détectée au sein de l'espace ouvert clos afin de commander le transfert de chaleur entre l'agent de refroidissement acheminé jusqu'à l'au moins une unité d'échange de chaleur intérieure par le deuxième circuit de refroidissement et une atmosphère au sein de l'espace ouvert clos.
